# EUROPÄISCHE PATENTSCHRIFT

(11) **EP 1 854 153 B1**
(45) Veröffentlichungstag und Bekanntmachung des Hinweises auf die Patenterteilung: **23.01.2019**
(21) Anmeldenummer: 06705919.6
(22) Anmeldetag: 06.02.2006
(51) Int. Cl.: H01L 25/075, H01L 33/42, H01L 33/50, H01L 33/62

(54) **LICHTEMITTIERENDE DIODENANORDNUNG (LED-ARRAY)**
LIGHT-EMITTING-DIODE (LED) ARRAY
RÉSEAU DE DIODES ÉLECTROLUMINESCENTES

(30) Priorität: 28.02.2005 DE 102005009059; 26.04.2005 DE 102005019375
(43) Veröffentlichungstag der Anmeldung: 14.11.2007
(73) Patentinhaber: OSRAM Opto Semiconductors GmbH, 93055 Regensburg (DE)
(72) Erfinder: BOGNER, Georg, 93138 Lappersdorf (DE); ENGL, Moritz, 93055 Regensburg (DE); GRÖTSCH, Stefan, 93077 Lengfeld/Bad Abbach (DE); KROMOTIS, Patrick, 93059 Regensburg (DE); SORG, Jörg Erich, 93053 Regensburg (DE)
(74) Vertreter: Epping - Hermann - Fischer
(86) Internationale Anmeldenummer: PCT/DE2006/000191
(87) Internationale Veröffentlichungsnummer: WO 2006/089508

(56) Entgegenhaltungen:
- DE-A1- 19 603 444
- DE-A1- 19 922 361
- US-A1- 2002 096 254
- US-A1- 2002 149 312
- US-A1- 2004 012 957
- US-A1- 2004 041 159
- US-A1- 2004 069 999
- US-A1- 2004 120 155
- TAKAHASHI K ET AL: "High density LED display panel on silicon microreflector and integrated circuit" ELECTRONIC MANUFACTURING TECHNOLOGY SYMPOSIUM, 1995, PROCEEDINGS OF 1995 JAPAN INTERNATIONAL, 18TH IEEE/CPMT INTERNATIONAL OMIYA, JAPAN 4-6 DEC. 1995, NEW YORK, NY, USA,IEEE, US, 4. Dezember 1995 (1995-12-04), Seiten 272-275, XP010195599 ISBN: 0-7803-3622-4

## Beschreibung

Die Erfindung betrifft eine lichtemittierende Diodenanordnung (LED-Array) nach dem Oberbegriff des Patentanspruchs 1.

LED-Arrays zeichnen sich durch eine hohe Effizienz, eine hohe Lebensdauer, eine schnelle Ansprechzeit und eine vergleichsweise geringe Empfindlichkeit gegen Stöße und Vibrationen aus. LED-Arrays können aus diesem Grund in Beleuchtungseinrichtungen eingesetzt werden, bei denen bisher oftmals Glühlampen verwendet wurden, insbesondere in KFZ-Scheinwerfern, Leselampen oder Taschenlampen. Aufgrund ihrer hohen Leuchtkraft sind LED-Arrays inzwischen auch für den Einsatz in Verkehrssignalanlagen oder Projektionslichtquellen geeignet.
Bei zu derartigen Beleuchtungszwecken eingesetzten LED-Arrays werden die LED-Chips in der Regel mit hohen Betriebsströmen betrieben, um eine möglichst hohe Leuchtdichte zu erzielen. Beispielsweise können Betriebsströme von 1 A oder mehr auftreten. Damit die elektrische Kontaktierung der Halbleiterchips derart hohen Stromstärken dauerhaft standhalten kann, werden zur Kontaktierung von Halbleiterchips in Hochleistungs-LED-Modulen typischerweise Bonddrähte verwendet, die einen Durchmesser von 30 *µ*m oder mehr aufweisen. Die Verwendung dieser vergleichsweise dicken Bonddrähte führt jedoch dazu, dass ein Teil der von den LEDs emittierten Strahlung durch die Bonddrähte abgeschattet wird. Weiterhin wird die Montage optischer Elemente dicht über der Oberfläche der Halbleiterchips durch die Bondrähte erschwert, da sich ihr Krümmungsradius und somit der von ihnen beanspruchte Raum über der Chipoberfläche nicht beliebig verkleinern lässt.

Bei Anwendungen von LED-Arrays, insbesondere bei Projektionslichtquellen, wird eine Lichtabstrahlung in einen möglichst engen Raumwinkelbereich gefordert. Da LEDs aber in der Regel einen vergleichsweise breiten Abstrahlwinkelbereich aufweisen, sind dazu optische Elemente erforderlich. Dabei ist es wünschenswert, die optischen Elemente möglichst dicht an die Halbleiterchips heranzuführen, um eine kompakte Bauweise zu erreichen und einen möglichst großen Anteil von den Halbleiterchips emittierten Strahlung ausnutzen zu können. Dieses wird durch die Kontaktierung mit Bonddrähten allerdings erschwert.

Aus der Druckschrift WO 98/12757 ist bekannt, einen optoelektronischen Halbleiterchip, der in herkömmlicher Weise mit einem Bonddraht kontaktiert ist, in eine Vergussmasse einzubetten, die Lumineszenz-Konversionsstoffe enthält, um zumindest einen Teil der von dem Halbleiterchip emittierten Strahlung zu größeren Wellenlängen hin zu konvertieren. Auf diese Weise kann zum Beispiel mit einem Halbleiterchip, der blaues oder ultraviolettes Licht emittiert, mischfarbiges oder weißes Licht erzeugt werden. Bei LED-Arrays, die mit vergleichsweise hohen Stromstärken betrieben werden, ist die Einbettung der Halbleiterchips in eine Vergussmasse aber problematisch, da die Vergussmasse die Wärmeabfuhr von den Halbleiterchips erschwert.

Weiterhin wird in der Druckschrift WO 97/50132 beschrieben, einen Lumineszenz-Konversionsschicht auf eine Abdeckplatte eines LED-Gehäuses aufzubringen, wobei in dem Gehäuse ein in herkömmlicher Weise mit einem Bonddraht kontaktierter LED-Chip positioniert ist.
In der Druckschrift DE 19603444 wird eine LED-Vorrichtung beschrieben, bei der LEDs mittels metallischer Leiterbahnen, die auf eine transparente Platte aufgebracht sind, kontaktiert sind. Bei dieser Art der Kontaktierung wird ein Teil der von den LEDs emittierten Strahlung in den metallischen Leiterbahnen absorbiert.

Die US 2002 / 0096254 offenbart die Kontaktierung der Halbleiterchips eines LED-Arrays durch auf einer Abdeckplatte aufgebrachte, transparente Leiterbahnen.

Der Erfindung liegt die Aufgabe zugrunde, die Divergenz der von dem Halbleiterchip emittierten Strahlung zu vermindern.

Diese Aufgabe wird durch ein LED-Array mit den Merkmalen des Patentanspruchs 1 gelöst. Vorteilhafte Ausgestaltungen und Weiterbildungen der Erfindung sind Gegenstand der abhängigen Ansprüche.
Bei einem erfindungsgemäßen LED-Array mit mehreren strahlungsemittierenden Halbleiterchips, die jeweils eine Strahlungsauskoppelfläche aufweisen, wobei die von den Halbleiterchips emittierte Strahlung im wesentlichen durch die Strahlungsauskoppelfläche ausgekoppelt wird, und einem für die emittierte Strahlung transparenten Abdeckkörper, weist der transparente Abdeckkörper auf einer Oberfläche, die den Strahlungsauskoppelflächen der Halbleiterchips zugewandt ist, eine oder mehrere Leiterbahnen aus einem für die emittierte Strahlung transparenten leitfähigen Material auf, und die Halbleiterchips weisen jeweils mindestens einen elektrischen Kontakt an der Strahlungsauskoppelfläche auf, der mit der Leiterbahn oder mit mindestens einer der mehreren Leiterbahnen verbunden ist.

Durch die Kontaktierung der Halbleiterchips mittels der mindestens einen auf den Abdeckkörper aufgebrachten transparenten Leiterbahn sind vorteilhaft keine Bonddrähte erforderlich, die die Montage optischer Elemente über den Halbleiterchips erschweren und/oder einen Teil der von den Halbleiterchips emittierten Strahlung abschatten würden. Die Verwendung einer für die emittierte Strahlung transparenten Leiterbahn hat den Vorteil, dass die Leiterbahn insbesondere in ihrer Dicke und ihrer Breite so dimensioniert werden kann, dass sie für hohe Stromstärken, zum Beispiel von 1 A oder mehr, tragfähig ist, ohne dass dabei eine Abschattung der strahlungsemittierenden Halbleiterchips erfolgt. Insbesondere besteht die Möglichkeit, die eine oder mehrere transparente Leiterbahnen auf Bereiche des Abdeckkörpers aufzubringen, durch welche die von den Halbleiterchips emittierte Strahlung hindurchtritt, ohne dass wesentliche Absorptionsverluste beim Betrieb des LED-Arrays auftreten. Dies erleichtert insbesondere die Verschaltung einer Vielzahl von strahlungsemittierenden Halbleiterchips in einem LED-Array zu einer Reihen- oder Parallelschaltung.

Das transparente leitfähige Material ist vorzugsweise ein transparentes leitfähiges Oxid. Insbesondere kann das transparente leitfähige Oxid Indium-Zinn-Oxid (ITO) sein.

Weiterhin ist bei einem LED-Array gemäß der Erfindung eine Wellenlängenkonversion zumindest eines Teils der von den Halbleiterchips emittierten Strahlung zu größeren Wellenlängen hin vorgesehen. Dazu ist vorteilhaft mindestens ein Lumineszenz-Konversionsstoff in dem Abdeckkörper enthalten und/oder in einer Schicht auf den Abdeckkörper und/oder auf den Halbleiterchip aufgebracht. Auf diese Weise kann beispielweise mit Halbleiterchips, die ultraviolette oder blaue Strahlung emittieren, Weißlicht erzeugt werden. Geeignete Lumineszenz-Konversionsstoffe, wie zum Beispiel YAG:CE (Y₃Al₅O₁₂:Ce³⁺), sind aus der WO 98/12757 bekannt, deren Inhalt hiermit durch Referenz aufgenommen wird.

Die elektrischen Kontakte der Halbleiterchips sind vorzugsweise mittels einem Lot oder einem elektrisch leitfähigen Klebstoff mit der mindestens einen auf den Abdeckkörper aufgebrachten Leiterbahn verbunden. Das Lot oder der elektrisch leitfähige Klebstoff kann beispielweise punktuell oder in einer beliebigen Struktur auf die Strahlungsauskoppelfläche der Halbleiterchips aufgebracht sein.

Der Abdeckkörper ist vorteilhaft eine Abdeckplatte. Vorzugsweise beträgt die Dicke der Abdeckplatte 100 *µ*m oder weniger, besonders bevorzugt 50 *µ*m oder weniger. Bei einer weiteren bevorzugten Ausgestaltung der Erfindung ist der Abdeckkörper eine transparente Abdeckfolie.

Der Abdeckkörper ist als strahlformendes optisches Element ausgebildet. Insbesondere kann die von den Halbleiterchips abgewandte Oberfläche des Abdeckkörpers als refraktives optisches Element, insbesondere in Form einer Linse, geformt oder strukturiert sein.

Das strahlformende optische Element ist ein Hohlkörper mit einer den Halbleiterchips zugewandten Lichteintrittsöffnung und einer der Lichteintrittsöffnung gegenüberliegenden Lichtaustrittsöffnung, wobei zumindest ein Teil der von dem oder den Halbleiterchip/s emittierten Strahlung an einer Wandung des Hohlkörpers zur Lichtaustrittsöffnung hin reflektiert wird.
Vorteilhaft wird die Divergenz der von dem Halbleiterchip emittierten Strahlung durch das strahlformende optische Element vermindert. Eine vorteilhafte Ausführung des strahlformenden optischen Elements besteht darin, dass sich der Querschnitt des Hohlkörpers von der Lichteintrittsöffnung zu der gegenüberliegenden Lichtaustrittsöffnung hin vergrößert. Weiterhin kann der Hohlkörper eine Symmetrieachse aufweisen, die parallel zu einer Hauptstrahlrichtung des strahlungsemittierenden Halbleiterchips ist.
Das strahlformende optische Element kann zum Beispiel ein mit einem Vergussmaterial gefüllter Hohlkörper sein. Bei dem Vergussmaterial handelt es sich bevorzugt um ein UV-stabiles Material, wie beispielsweise Silikon.

Eine Wandung des Hohlkörpers weist eine Krümmung auf, um eine gewünschte optische Funktionalität zu realisieren. Die Wandung des Hohlkörpers kann parabolisch, elliptisch oder hyperbolisch, gekrümmt sein.
Das strahlformende optische Element ist beispielsweise als ein CPC-, CEC- oder CHC-artiger optischer Konzentrator ausgebildet, womit hierbei sowie im folgenden ein Konzentrator gemeint ist, dessen reflektierende Seitenflächen zumindest teilweise und/oder zumindest weitestgehend die Form eines zusammengesetzten parabolischen Konzentrators (Compound Parabolic Concentrator, CPC), eines zusammengesetzten elliptischen Konzentrators (Compound Elliptic Concentrator, CEC) oder eines zusammengesetzten hyperbolischen Konzentrators (Compound Hyperbolic Concentrator, CHC) aufweisen. Dabei ist die den Halbleiterchips zugewandte Oberfläche des Abdeckkörpers der eigentliche Konzentratorausgang, so dass Strahlung, verglichen mit der üblichen Anwendung eines Konzentrators zum Fokussieren, in umgekehrter Richtung durch diesen läuft und somit nicht konzentriert wird, sondern den Abdeckkörper mit verringerter Divergenz durch die gegenüberliegende Oberfläche verlässt.

Der Abdeckkörper ist vorzugsweise aus einem Material gebildet, dessen thermischer Ausdehnungskoeffizient im wesentlichen mit dem thermischen Ausdehnungskoeffizienten des Halbleitermaterials der Halbleiterchips übereinstimmt. Dadurch werden durch Temperaturänderungen bedingte mechanische Spannungen zwischen den Halbleiterchips und dem Abdeckkörper, die ansonsten zu einer Schädigung oder sogar einem Bruch der Verbindung führen könnten, vorteilhaft verringert.

In einer bevorzugten Ausführungsform der Erfindung ist der Abdeckkörper aus einem Glas, besonders bevorzugt aus einem Borosilikatglas, gebildet.

Im Hinblick auf die Effizienz der Lumineszenz-Konversion ist es besonders vorteilhaft, wenn der Abdeckkörper einen vergleichsweise geringen Abstand zu den zur Strahlungsauskopplung vorgesehenen Strahlungsauskoppelflächen der Halbleiterchips aufweist. Der Abdeckkörper ist vorteilhaft nur durch ein Lot oder einen elektrisch leitfähigen Klebstoff von dem Abdeckkörper beanstandet. Insbesondere kann der Abdeckkörper teilweise oder sogar ganz auf der Strahlungsauskoppelfläche der Halbleiterchips aufliegen. Weiterhin ist es auch möglich, dass ein Zwischenraum zwischen den Halbleiterchips und der Abdeckplatte mit Silikon ausgefüllt ist, um insbesondere einen Brechungsindexsprung zwischen den Halbleiterchips und dem Umgebungsmedium zu vermindern und somit die Auskopplung der Strahlung aus den Halbleiterchips zu verbessern.

Die Halbleiterchips enthalten vorzugsweise ein III-V-Verbindungshalbleitermaterial, insbesondere InₓAl_{y}Ga_{1-x-y}N, InₓAl_{y}Ga_{1-x-y}P oder InₓAl_{y}Ga_{1-x-y}AS, jeweils mit 0≤x≤1, 0≤y≤1 und x+y≤1. Dabei muss das III-V-Verbindungshalbleitermaterial nicht zwingend eine mathematisch exakte Zusammensetzung nach einer der obigen Formeln aufweisen. Vielmehr kann es einen oder mehrere Dotierstoffe sowie zusätzliche Bestandteile aufweisen, die die physikalischen Eigenschaften des Materials im Wesentlichen nicht ändern. Der Einfachheit halber beinhalten obige Formeln jedoch nur die wesentlichen Bestandteile des Kristallgitters, auch wenn diese teilweise durch geringe Mengen weiterer Stoffe ersetzt sein können.

Die Halbleiterchips weisen vorteilhaft eine der Strahlungsauskoppelfläche gegenüberliegende Grundfläche auf, mit der sie auf einen Trägerkörper montiert sind. Besonders bevorzugt sind die Halbleiterchips des LED-Arrays auf einem gemeinsamen Trägerkörper montiert. Der Trägerkörper ist vorzugsweise aus einer Metallkeramik, beispielsweise AlN, gefertigt.

Besonders bevorzugt sind die Halbleiterchips sogenannte Dünnfilm-Leuchdiodenchips, bei denen eine funktionelle Halbleiterschichtenfolge zunächst epitaktisch auf einem Aufwachssubstrat aufgewachsen wurde, anschließend ein neuer Träger auf die dem Aufwachssubstrat gegenüberliegende Oberfläche der Halbleiterschichtenfolge aufgebracht und nachfolgend das Aufwachssubstrat abgetrennt wurde. Dies hat insbesondere den Vorteil, dass das Aufwachssubstrat wiederverwendet werden kann.

Ein Dünnfilm-Leuchtdioden-Chip zeichnet sich insbesondere durch folgende charakteristische Merkmale aus:
- an einer zu einem Träger hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20*µ*m oder weniger, insbesondere im Bereich von 10 *µ*m auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Ein Dünnfilm-Leuchtdioden-Chip ist in guter Näherung ein Lambert'scher Oberflächenstrahler und eignet sich von daher besonders gut für die Anwendung in einem Scheinwerfer.

Bei einer weiteren bevorzugten Ausführungsform enthält das LED-Array mindestens vier strahlungsemittierende Halbleiterchips. Diese sind vorzugsweise mit der mindestens einen Leiterbahn miteinander verschaltet. Bei dem LED-Array können beispielweise mehrere Halbleiterchips mittels der mindestens einen Leiterbahn in Form einer Reihen- oder Parallelschaltung miteinander verbunden sein.

Ein LED-Array gemäß der Erfindung kann beispielweise ein Teil einer Beleuchtungseinrichtung, insbesondere ein Teil eines KFZ-Scheinwerfers oder einer Projektionslichtquelle, sein.

Es zeigen:

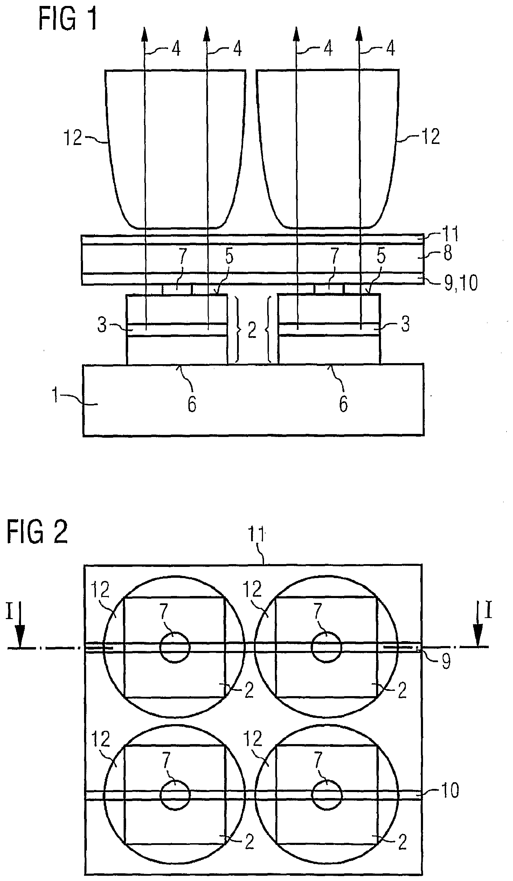

- Figur 1: eine schematische Darstellung eines Querschnitts durch ein Ausführungsbeispiel eines LED-Arrays und
- Figur 2: eine schematische Darstellung einer Aufsicht auf das in Figur 1 dargestellte Ausführungsbeispiel eines LED-Arrays.
Gleiche oder gleichwirkende Elemente sind in den Figuren mit den gleichen Bezugszeichen versehen.
Bei dem in der Figur 1 in einem Querschnitt entlang der Linie I-I und in der Figur 2 in einer Aufsicht dargestellten LED-Array sind vier strahlungsemittierende Halbleiterchips 2 auf einen gemeinsamen Trägerkörper 1 montiert.
Die Halbleiterchips 2 weisen eine aktive Zone 3 auf, die vorzugsweise ein III-V-Verbindungshalbleitermaterial, insbesondere InₓAl_{y}Ga_{1-x-y}N, InₓAl_{y}Ga_{1-x-y}P oder InₓAl_{y}Ga_{1-x-y}As mit 0≤ x≤1, 0≤y≤1 und x+y≤1, enthält. Die aktive Zone 3 kann als Single-Heterostruktur, Doppel-Heterostruktur, Einfach-Quantentopfstruktur oder Mehrfach-Quantentopfstruktur ausgebildet sein. Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit u.a. Quantentröge, Quantendrähte und Quantenpunkte und jede Kombination dieser Strukturen.

Die von den Halbleiterchips 2 emittierte Strahlung 4 wird jeweils im wesentlichen durch eine Strahlungsauskoppelfläche 5, die einer Grundfläche 6 der Halbleiterchips 2, mit der die Halbleiterchips 2 auf dem gemeinsamen Trägerkörper 1 montiert sind, gegenüberliegt, ausgekoppelt.

An ihrer Strahlungsauskoppelfläche 5 weisen die Halbleiterchips 2 jeweils mindestens einen elektrischen Kontakt 7 auf, der beispielweise aus einem Lot oder einem elektrisch leitfähigen Klebstoff gebildet ist. Mittels der elektrischen Kontakte 7 sind die Halbleiterchips 2 jeweils mit mindestens einer Leiterbahn 9, 10, die auf eine den Halbleiterchips 2 zugewandte Oberfläche eines Abdeckkörpers 8 aufgebracht ist, elektrisch leitend verbunden.

Die Halbleiterchips 2 weisen beispielsweise jeweils einen weiteren elektrischen Kontakt an der Grundfläche 6 auf. Alternativ können die Halbleiterchips 2 sowohl einen n-Kontakt als auch einen p-Kontakt an der Strahlungsauskoppelfläche 5 aufweisen.

Die Leiterbahnen 9, 10 sind aus einem transparenten, leitfähigen Material, insbesondere aus einem transparenten leitfähigen Oxid, wie beispielweise ITO, gebildet. Dies hat den Vorteil, dass auch dann keine wesentliche Absorption der emittierten Strahlung 4 in den Leiterbahnen 9, 10 erfolgt, wenn die Halbleiterchips 2 in ihrer Hauptstrahlungsrichtung durch die Leiterbahnen 9, 10 hindurch Strahlung 4 emittieren. Dies erleichtert insbesondere dann die Führung der Leiterbahnen, wenn eine Vielzahl von Halbleiterchips 2, beispielweise vier oder mehr, in einem LED-Array angeordnet sind.

Der für die von den Halbleiterchips 2 emittierte Strahlung 4 transparente Abdeckkörper 8 ist vorteilhaft aus einem Glas, besonders bevorzugt aus einem Borosilikatglas, gebildet. Beispielweise ist der Abdeckkörper 8 eine Glasplatte. Alternativ kann der Abdeckkörper 8 auch aus einem transparenten Kunststoff, der vorzugsweise eine hohe UV-Beständigkeit aufweist, gebildet sein. Insbesondere kann der Abdeckkörper eine Abdeckfolie sein. Neben seiner Funktion als Träger der Leiterbahnen 9, 10 stellt der Abdeckkörper 8 vorteilhaft auch einen Schutz der Halbleiterchips 2 vor Schmutz oder Feuchtigkeit dar.

Mit Vorteil sind dem Abdeckkörper 8 Lumineszenz-Konversionsstoffe zugesetzt, um zumindest einen Teil der von den Halbleiterchips 2 emittierten Strahlung 4 zu einer größeren Wellenlänge hin zu konvertieren. Beispielsweise handelt es sich dabei um Lumineszenz-Konversionsstoffe, welche die von den Halbleiterchips 2 emittierte ultraviolette und/oder blaue Strahlung in den komplementären Spektralbereich, insbesondere in den gelben Spektralbereich konvertiert, um auf diese Weise weißes oder mischfarbiges Licht zu erzeugen. Die Lumineszenz-Konversionsstoffe können einerseits dem Material, aus dem der Abdeckkörper 8 gebildet ist, zugesetzt sein. Weiterhin ist es denkbar, dass eine Schicht 11, welche die Lumineszenz-Konversionsstoffe enthält, auf eine Oberfläche des Abdeckkörpers 8, welche von der von den Halbleiterchips 2 in eine Hauptstrahlrichtung emittierte Strahlung 4 durchdrungen wird, aufgebracht ist. Beispielsweise kann eine Schicht 11, welche Lumineszenz-Konversionsstoffe enthält, auf die von den Leiterbahnen 9, 10 abgewandte Oberfläche des Abdeckkörpers 8 aufgebracht sein. Alternativ ist es auch möglich, dass die Lumineszenz-Konversionsstoffe enthaltende Schicht auf die den Halbleiterchips 2 zugewandte Oberfläche des Abdeckkörpers 8 aufgebracht ist. Ferner kann die Lumineszenz-Konversionsstoffe enthaltende Schicht auf die Strahlungsauskoppelfläche 5 der Halbleiterchips 2 aufgebracht sein.
Dem Abdeckkörper 8 können von den Halbleiterchips 2 aus gesehen vorteilhaft eines oder mehrere optische Elemente 12 nachgeordnet sein, die zur Strahlführung und/oder Strahlformung der von den Halbleiterchips 2 emittierten Strahlung 4 dienen. Insbesondere können optische Elemente 12 vorgesehen sein, welche die Divergenz der von den Halbleiterchips 2 emittierten Strahlung 4 verringern. Beispielsweise kann es sich bei den optischen Elementen 12 um einen CPC-, CEC- oder CHC-artigen optischen Konzentrator handeln, der vorzugsweise sehr nah an der Abdeckplatte 8 angeordnet oder sogar auf diese aufgesetzt ist.

Der Abdeckkörper ist als optisches Element ausgebildet. Beispielsweise wird dazu eine von den Halbleiterchips 2 abgewandte Oberfläche des Abdeckkörpers 8 als refraktives oder diffraktives optisches Element ausgebildet. Insbesondere kann die von den Halbleiterchips 2 abgewandte Oberfläche des Abdeckkörpers 8 linsenartig nach außen gewölbt sein. Weiterhin können auch die Seitenflächen des Abdeckkörpers 8 eine gekrümmte Form aufweisen und/oder schräg zur Hauptstrahlrichtung der von den Halbleiterchips 2 emittierten Strahlung 4 verlaufen.

## Patentansprüche

1. Lichtemittierende Diodenanordnung (LED-Array) mit mehreren strahlungsemittierenden Halbleiterchips (2), die jeweils eine Strahlungsauskoppelfläche (5) aufweisen, wobei die von den Halbleiterchips (2) emittierte Strahlung (4) im wesentlichen durch die Strahlungsauskoppelfläche (5) ausgekoppelt wird, und einem für die emittierte Strahlung (4) transparenten Abdeckkörper (8), wobei
- der transparente Abdeckkörper (8) auf einer Oberfläche, die den Strahlungsauskoppelflächen (5) der Halbleiterchips (2) zugewandt ist, eine oder mehrere Leiterbahnen (9,10) aus einem für die emittierte Strahlung (4) transparenten leitfähigen Material aufweist, wobei die Halbleiterchips (2) jeweils mindestens einen elektrischen Kontakt (7) an der Strahlungsauskoppelfläche (5) aufweisen, der mit der Leiterbahn (9, 10) oder mit mindestens einer der mehreren Leiterbahnen (9, 10) verbunden ist,
**dadurch gekennzeichnet, dass**
- mindestens ein Lumineszenzkonversionsstoff in dem transparenten Abdeckkörper (8) enthalten und/oder in einer Schicht (11) auf den Abdeckkörper (8) und/oder auf die Halbleiterchips (2) aufgebracht ist, und
- der transparente Abdeckkörper (8) als optisches Element zur Strahlformung der von den Halbleiterchips (2) emittierten Strahlung ausgebildet ist, wobei
- der Abdeckkörper (8) ein mit einem Vergussmaterial gefüllter Hohlkörper ist, der zur Realisierung einer optischen Funktionalität eine parabolisch, elliptisch oder hyperbolisch gekrümmte Wandung aufweist.

2. LED-Array nach Anspruch 1,
**dadurch gekennzeichnet, dass**
das transparente leitfähige Material ein transparentes leitfähiges Oxid ist.

3. LED-Array nach Anspruch 2,
**dadurch gekennzeichnet, dass**
das transparente leitfähige Oxid ITO ist.

4. LED-Array nach einem der vorhergehenden Ansprüche,
**dadurch gekennzeichnet, dass**
der Abdeckkörper (8) aus einem Glas gebildet ist.

5. LED-Array nach einem der vorhergehenden Ansprüche,
**dadurch gekennzeichnet, dass**
der elektrische Kontakt (7) aus einem Lot oder einem elektrisch leitfähigen Klebstoff gebildet ist.

6. LED-Array nach einem der vorhergehenden Ansprüche,
**dadurch gekennzeichnet, dass**
die Halbleiterchips (2) eine der Strahlungsauskoppelfläche (5) gegenüberliegende Grundfläche (6) aufweisen, wobei die Halbleiterchips (2) mit der Grundfläche (6) auf einen Trägerkörper (1) montiert sind.

7. LED-Array nach einem der vorhergehenden Ansprüche,
**dadurch gekennzeichnet, dass**
es mindestens vier strahlungsemittierende Halbleiterchips (2) enthält.

8. LED-Array nach einem der vorhergehenden Ansprüche,
**dadurch gekennzeichnet, dass**
ein Abstand zwischen dem optischen Element (12) und der Strahlungsauskoppelfläche (5) 300 µm oder weniger beträgt.

9. LED-Array nach einem der vorhergehenden Ansprüche,
**dadurch gekennzeichnet, dass**
das optische Element (12) ein CPC-, CEC- oder CHC-artiger optischer Konzentrator ist.

10. LED-Array nach einem der vorhergehenden Ansprüche,
**dadurch gekennzeichnet, dass**
die Halbleiterchips (2) ein III-V-Verbindungshalbleitermaterial enthalten.

11. LED-Array nach einem der vorhergehenden Ansprüche,
**dadurch gekennzeichnet, dass**
die Halbleiterchips (2) Dünnfilm-Leuchtdiodenchips sind.

12. LED-Array nach einem der vorhergehenden Ansprüche, bei dem eine von den Halbleiterchips (2) abgewandte Oberfläche des Abdeckkörpers (8) ein refraktives oder diffraktives optisches Element ist.

13. LED-Array nach einem der vorhergehenden Ansprüche, bei dem eine von den Halbleiterchips (2) abgewandte Oberfläche des Abdeckkörpers (8) linsenförmig nach außen gewölbt ist.

## Claims

1. Light-emitting diode arrangement (LED array) having a plurality of radiation-emitting semiconductor chips (2) which each have a radiation coupling-out surface (5), the radiation (4) emitted by the semiconductor chips (2) being substantially coupled out by the radiation coupling-out surface (5), and having a cover body (8) which is transparent for the emitted radiation (4), wherein
- the transparent cover body (8) has one or more conductor tracks (9, 10) on a surface which faces the radiation coupling-out surfaces (5) of the semiconductor chips (2) and is made of a conductive material which is transparent to the emitted radiation (4), the semiconductor chips (2) each having at least one electrical contact (7) on the radiation coupling-out surface (5) which is connected to the conductor track (9, 10) or to at least one of the plurality of conductor tracks (9, 10),
**characterised in that**
- at least one luminescence conversion material is contained in the transparent cover body (8) and/or is applied in a layer (11) to the cover body (8) and/or to the semiconductor chips (2), and
- the transparent cover body (8) is formed as an optical element for beam shaping the radiation emitted by the semiconductor chips (2), wherein
- the cover body (8) is a hollow body which is filled with a potting material and has a parabolically, elliptically or hyperbolically curved wall for the realisation of an optical functionality.

2. LED array according to claim 1,
**characterised in that**
the transparent conductive material is a transparent conductive oxide.

3. LED array according to claim 2,
**characterised in that**
the transparent conductive oxide is ITO.

4. LED array according to one of the preceding claims, **characterised in that**
the cover body (8) is formed of a glass.

5. LED array according to one of the preceding claims, **characterised in that**
the electrical contact (7) is formed from a solder or an electrically conductive adhesive.

6. LED array according to one of the preceding claims, **characterised in that**
the semiconductor chips (2) have a base surface (6) which is opposite the radiation coupling-out surface (5), the semiconductor chips (2) being mounted with the base surface (6) on a carrier body (1).

7. LED array according to one of the preceding claims, **characterised in that**
it contains at least four radiation-emitting semiconductor chips (2).

8. LED array according to one of the preceding claims, **characterised in that**
a distance between the optical element (12) and the radiation coupling-out surface (5) is 300 µm or less.

9. LED array according to one of the preceding claims, **characterised in that**
the optical element (12) is a CPC-, CEC- or CHC-like optical concentrator.

10. LED array according to one of the preceding claims, **characterised in that**
the semiconductor chips (2) comprise a III-V compound semiconductor material.

11. LED array according to one of the preceding claims, **characterised in that**
the semiconductor chips (2) are thin-film light-emitting diode chips.

12. LED array according to one of the preceding claims,
in which a surface of the cover body (8) remote from the semiconductor chips (2) is a refractive or diffractive optical element.

13. LED array according to one of the preceding claims,
in which a surface of the cover body (8) which faces away from the semiconductor chips (2) is curved outwards in the form of a lens.

## Revendications

1. Réseau de diodes électroluminescentes (rangée de LED) comportant une pluralité de puces semi-conductrices émettrices de rayonnement (2) présentant chacune une surface de découplage de rayonnement (5),
le rayonnement (4) émis par les puces semi-conductrices (2) étant sensiblement découplé par la surface de découplage de rayonnement (5), et un corps de couvercle (8) transparent au rayonnement émis (4),
dans lequel
- le corps de couvercle transparent (8) présente une ou plusieurs pistes conductrices (9, 10) sur une surface tournée vers les surfaces de découplage de rayonnement (5) des puces semi-conductrices (2) et est constitué d'un matériau conducteur transparent au rayonnement émis (4), les puces semi-conductrices (2) présentant chacune sur la surface de découplage de rayonnement (5) au moins un contact électrique (7) relié à la piste conductrice (9, 10) ou au moins à l'une des plusieurs pistes conductrices (9, 10),
**caractérisé en ce que**
- au moins un matériau de conversion de luminescence figure dans le corps de couvercle transparent (8) et/ou est appliqué dans une couche (11) sur le corps de couvercle (8) et/ou sur les puces semi-conductrices (2), et
- le corps de couvercle (8) transparent est conçu en tant qu'élément optique pour la formation du faisceau émis par les puces semi-conductrices (2),
- le corps de couvercle (8) étant un corps creux rempli d'un matériau de scellement, qui présente une paroi de forme parabolique, elliptique ou hyperbolique pour la réalisation d'une fonctionnalité optique.

2. Rangée de LED selon la revendication 1,
**caractérisée en ce que**
le matériau conducteur transparent est un oxyde conducteur transparent.

3. Rangée de LED selon la revendication 2,
**caractérisée en ce que**
est l'oxyde conducteur transparent ITO.

4. Rangée de LED selon l'une des revendications précédentes, **caractérisée en ce que**
le corps de couvercle (8) est formé d'un verre.

5. Rangée de LED selon l'une des revendications précédentes, **caractérisée en ce que**
le contact électrique (7) est formé à partir d'une soudure ou d'une colle conductrice d'électricité.

6. Rangée de LED selon l'une des revendications précédentes, **caractérisée en ce que**
les puces semi-conductrices (2) ont une surface de base (6) opposée à la surface de découplage de rayonnement (5), les puces semi-conductrices (2) étant montées avec la surface de base (6) sur un corps porteur (1).

7. Rangée de LED selon l'une des revendications précédentes, **caractérisée en ce qu'**elle
contient au moins quatre puces semi-conductrices émettrices de rayonnement (2).

8. Rangée de LED selon l'une des revendications précédentes, **caractérisée en ce que**
la distance entre l'élément optique (12) et la surface de découplage de rayonnement (5) est égale ou inférieure à 300 µm.

9. Rangée de LED selon l'une des revendications précédentes, **caractérisée en ce que**
l'élément optique (12) est un concentrateur optique de type CPC, CEC ou CHC.

10. Rangée de LED selon l'une des revendications précédentes, **caractérisée en ce que**
les puces semi-conductrices (2) contiennent un matériau de connexion semi-conducteur III-V.

11. Rangée de LED selon l'une des revendications précédentes, **caractérisée en ce que**
les puces semi-conductrices (2) sont des puces de diode électroluminescente à couche mince.

12. Rangée de LED selon l'une des revendications précédentes, dans laquelle une surface du corps de couvercle (8) détournée des puces semi-conductrices (2) est un élément optique réfractif ou diffractif.

13. Rangée de LED selon l'une des revendications précédentes, dans laquelle une surface du corps de couvercle (8) détournée des puces semi-conductrices (2) est incurvée vers l'extérieur d'une manière lenticulaire.
